# EUROPEAN PATENT APPLICATION

(11) **EP 1 357 428 A1**
(43) Date of publication of application: **29.10.2003**
(21) Application number: 03291002.8
(22) Date of filing: 24.04.2003
(51) Int. Cl.: G03F 7/039, C08F 120/02

(54) **Alcoholic hydroxyl group-, aromatic ring- and protolytically leaving group-containing copolymer**

(30) Priority: 26.04.2002 JP 2002126419
(71) Applicant: Nippon Shokubai Co., Ltd., Osaka-shi, Osaka 541-0043 (JP)
(72) Inventor: Murakami, Yohei, Suita-shi, Osaka 564-0023 (JP); Yoshida, Masatoshi, Nara-shi, Nara 631-0036 (JP); Konosu, Osamu, Takatsuki-shi, Osaka 569-0854 (JP); Goto, Shinichi, Kakogawa-shi, Hyogo 675-0017 (JP); Arakawa, Motohiro, Mino-shi, Osaka 562-001 (JP); Ugamura, Tadayoshi, Suita-shi, Osaka 564-0035 (JP)
(74) Representative: Hubert, Philippe

(57) **Abstract**

It is an object of the present invention, which has been made in view of the above-mentioned state of the art, to provide a protolytically leaving group-containing copolymer which can exhibit high levels of changes in characteristics, such as solubility in alkaline aqueous solutions after free proton treatment as compared with the, solubility before such treatment, and of substrate adhesion, developability, chemical resistance and etching resistance and which can judiciously be applied in various fields of application.

The present invention is related to a protolytically leaving group-containing copolymer which is a copolymer having hydroxyl groups each bound to the main chain thereof via one carbon atom, aromatic rings, and protolytically leaving groups, wherein said protolytically leaving group-containing copolymer showing an alkali dissolution rate of 20 × 10⁻¹⁰ to 1,500 × 10⁻¹⁰ m/second prior to protolytically leaving group elimination.

## Description

### FIELD OF THE INVENTION

The present invention relates to protolytically leaving group-containing copolymers.

### BACKGROUND ART

Protolytically leaving group (proton-sensitive leaving group)-containing copolymers have groups capable of being eliminated under the action of free protons and thereby replaced by hydrogen atoms and have a property such that certain characteristics, such as solubility in alkaline aqueous solutions, are modified upon exchange of such groups for hydrogen atoms. When such a copolymer is irradiated with light, plasma or some other radiation and/or heated in the presence of an acid catalyst, which is to serve as a proton donor, for generation of free protons from the acid catalyst, the characteristics thereof, such as solubility in alkaline aqueous solutions, are substantially modified as compared with those before irradiation and/or heating. By making a good use of such properties, it becomes possible to apply the copolymer in various fields of chemical industry, for example as a photolithographic material or in low-shrinkage materials which utilize the volume expansion resulting from olefin generation under the action of the acid catalyst.

Such protolytically leaving group-containing copolymers are required to be excellent in adhesion to various substrates and show a good balance between the restraint of dissolution in an alkaline aqueous solution prior to treatment with free protons and the solubility in the alkaline aqueous solution after such treatment so that the quality of development, such as the contrast between developed soluble portions and undeveloped insoluble portions, can be improved when they are used as photolithographic materials, for instance. It is known, for example, that the adhesion to substrates and/or the quality of development can be improved by introducing hydroxyl groups into such polymers. In this regard, Japanese Kokai Publication 2000-275843 discloses, concerning a chemical amplification type positive resist composition comprising a copolymer resulting from polymerization of 2-hydroxyethyl methacrylate, that the adhesion to substrates can be secured and the resist improved in resolution and dry etching resistance by introducing hydroxy groups into the copolymer. However, the hydroxy groups are introduced into side chains of the copolymer and thus at sites fairly distant from the main chain thereof. There is thus room for contrivance for improving the adhesion to substrates and/or the developability by substantially modifying the properties of the copolymer.

Japanese Kokai Publication 2000-206694, which is concerned with a photosensitive resin whose main chain has methylol groups, discloses a negative type resist composition which comprises a polymer comprising an α-(hydroxyalkyl)acrylic acid alkyl ester enabling development with an alkali. However, this photosensitive resin has no benzene ring in the copolymer and, therefore, the use of such resin as a resist resin, for instance, results in poor chemical resistance and/or poor etching resistance. Thus, in such respect, there is room for contrivance.

Japanese Kokai Publication 2000-131847, which is concerned with a resist composition obtained by copolymerizing a hydroxymethylacrylate, discloses that the copolymer obtained by polymerization using, as an essential constituent monomer, a monomer having a hydoxymethyl group and a leaving group including a tert-butyl group is excellent in sensitivity and/or resist pattern forming ability and in adhesion to substrates and dry etching resistance. Styrene, hydroxystyrene, 4-tert-butoxystyrene and others are mentioned as the other copolymerizable components. Such resist composition is indeed suited for use as an ArF resist composition but, when an aromatic ring, typically the benzene ring capable of giving good chemical resistance and etching resistance, is introduced into such a copolymer, the benzene ring absorbs ArF excimer laser beams (wavelength 193 nm). Thus, such composition becomes opaque, and only the superficial portion of the coatings can be exposed to light or the like. Therefore, there is room for contrivance for producing improvements in all of the characteristics in question, namely adhesion to substrates, behavior in development, chemical resistance and etching resistance, by adequately selecting the aromatic ring-containing monomer or the proportion thereof in the monomer composition for copolymerization.

### SUMMARY OF THE INVENTION

Accordingly, it is an object of the present invention, which has been made in view of the above-mentioned state of the art, to provide a protolytically leaving group-containing copolymer which can exhibit high levels of changes in characteristics, such as solubility in alkaline aqueous solutions after free proton treatment as compared with the solubility before such treatment, and of substrate adhesion, developability, chemical resistance and etching resistance and which can judiciously be applied in various fields of application.

The present inventors made various investigations concerning protolytically leaving group-containing copolymers. As a result, paid their attention to the fact that when such a copolymer is used in photosensitive resist resin compositions or like compositions, for instance, it is important for the copolymer to be compatible with water so that development with an alkaline aqueous solution can be effected following formation of membranes or coatings therefrom, they found that hydroxyl group introduction into such copolymers is effective for such purposes and that when hydroxyl groups are introduced into sites close to the main chain, not into side chains, the properties of the copolymer can be substantially modified. They also found that it is effective, for substantially modifying the properties of the copolymer by hydroxyl group introduction thereinto at sites close to the main chain, to introduce hydroxyl groups into the copolymer by causing each of them bound to the main chain via one carbon atom, whereby the compatibility with a highly polar developer, such as an aqueous developer, is improved, the dissolution is improved owing to sufficient penetration of the developer into depressions on the occasion of development of fine patterns, for instance, and, further, the adhesion to substrates is improved owing to the polarity of hydroxyl groups. It is to be noted that when hydroxyl groups are directly bound to the main chain, as in polyvinyl alcohol, the degree of freedom of rotation of the main chain decreases and the interactions among polymer molecules become excessively strong, leading to a decrease in flexibility, and, from the copolymer production viewpoint, a vinyl ester monomer copolymer hydrolyzing procedure becomes necessary because of the vinyl alcohol monomer being very unstable, rendering the copolymer production procedure complicated.

Further, paid their attention to the drawback that when aromatic rings, in particular benzene rings through the use of styrene, are introduced into the copolymer in addition to the hydroxyl group introduction thereinto at sites close to the main chain, the resulting copolymer, when used in resist materials, for example, exhibits good chemical resistance and etching resistance, among others, but, on the contrary, the hydrophobicity thereof becomes disadvantageously strong, worsening the compatibility with the developer, the inventors found that when the rate of dissolution of the copolymer in an alkaline solution prior to the elimination of the protolytically-leaving groups is 20 X 10⁻¹⁰ to 1,500 X 10⁻¹⁰ m/sec, the above object can successfully be accomplished, namely the drawback of strong hydrophobicity is removed, the chemical resistance and etching resistance, among others, are improved, and the adhesion to substrates, developability, chemical resistance and etching resistance are exhibited all at high levels. Based on these findings, the present invention has now been completed.

The present invention can be suitably used for various types of KrF resist. Specific examples thereof are the one called t-BOC type resist in which a leaving group is t-butoxy carbonyl group, the one called acetal type resist or ketal type resist in which a leaving group is 1-ethoxyethyl group, tetrahydropyranyl group or the like, and the one called High Activation Energy Resist in which a leaving group is t-butyl group or the like and strong energy is required for elimination of the leaving group.

The present invention thus provides a protolytically leaving group-containing copolymer which is a copolymer having hydroxyl groups each bound to the main chain thereof via one carbon atom, aromatic rings, and protolytically leaving groups and shows an alkali dissolution rate of 20 X 10⁻¹⁰ to 1,500 X 10⁻¹⁰ m/second before protolytically leaving group elimination. Thus, the protolytically leaving group-containing copolymer of the present invention is an alcoholic hydroxyl group-, aromatic ring- and protolytically leaving group-containing copolymer.

### DETAILED DESCRIPTION OF THE INVENTION

In the following, the present invention is described in detail.

The protolytically leaving group-containing copolymer of the present invention has hydroxyl groups each bound to the main chain thereof via one carbon atom, aromatic rings, and protolytically leaving groups. The main chain so referred to herein means that chain portion which is formed by bonding of repeating units (monomer units). The carbon atom binding the hydroxyl group to the main chain may have a substituent or may not have any substituent. The substituent is not particularly restricted but includes straight alkyl groups, branched alkyl groups, alicyclic alkyl groups, and aromatic rings, among others. Preferred as the aromatic ring are the benzene, naphthalene, anthracene and like rings. The benzene ring is most preferred, however. The aromatic ring may have one or more substituents or may not have any substituent. Such substituents are not particularly restricted but may be selected from among hydroxyl, alkoxyl, carboxyl, straight alkyl, branched alkyl, alicyclic alkyl and aromatic ring groups, among others.

The term "protolytically leaving group" as used herein means a group capable of being eliminated under the action of a free proton and thus replaced by a hydrogen atom. The conditions for that elimination are not particularly restricted. Free protons can be given to the copolymer by irradiating, with light, plasma or like radiation, or by heating the copolymer in the presence of an acid catalyst, which is to serve as a proton donor, to thereby cause free proton generation from the acid catalyst. Suited for use as such acid catalyst are onium salts, sulfone compounds, sulfonic acid ester compounds, sulfonimide compounds, diazomethane compounds, organic sulfonic acids such as p-toluenesulfonic acid, benzenesulfonic acid and trifluoromethanesulfonic acid, hydrochloric acid, sulfuric acid, nitric acid, and the like. These may be used singly or two or more of them may be used in combination.

In accordance with the present invention, the protolytically leaving group-containing copolymer mentioned above has an alkali dissolution rate of 20 X 10⁻¹⁰ to 1,500 × 10⁻¹⁰ m/sec prior to the protolytically leaving group elimination. When the rate is lower than 20 X 10⁻¹⁰ m/sec, the compatibility or adaptability of the copolymer with or to the developer on the occasion of development will be insufficient and, when it exceeds 1,500 X 10⁻¹⁰ m/sec, the difference in dissolution rate before and after proton-induced leaving group elimination becomes small, with the result that the contrast between exposed portions and unexposed portions becomes unsatisfactory. Preferably, the rate is not less than 30 X 10⁻¹⁰ m/sec but not more than 1,200 X 10⁻¹⁰ m/sec, more preferably not less than 30 X 10⁻¹⁰ m/sec but not more than 1,000 X 10⁻¹⁰ m/sec, still more preferably not less than 30 X 10⁻¹⁰ m/sec but not more than 800 X 10⁻¹⁰ m/sec, most preferably 30 X 10⁻¹⁰ m/sec but not more than 600 X 10⁻¹⁰ m/sec.

The above-mentioned alkali dissolution rate is expressed in terms of the thickness of the membrane formed from the copolymer on a substrate as dissolved per second (m/sec) when the membrane is immersed in an alkaline solution. An appropriate method of measurement comprises applying the copolymer to a silicon substrate, which is treated in advance with tetramethyldisilazane for rendering the same hydrophobic, to a dry membrane thickness of 1 µm by spin coating method, evaporating the solvent by heating the substrate on a hot plate at 130°C, immersing the substrate in an alkaline solution at 23°C for a predetermined period of time (e.g. about 120 seconds), and measuring the membrane thickness before and that after immersion using "DEKTAK II A Surface Roughness Measuring System" (trademark; product of Nippon Shinku Gijutu (ULVAC Japan)). For membrane thickness measurements, a portion of the membrane is scraped off to reveal the silicon substrate, and the difference in level between the membrane surface and substrate surface is determined. The rate of dissolution is determined by subtracting the membrane thickness after immersion from the membrane thickness before immersion and dividing the difference by the time of immersion. In cases where the membrane is completely dissolved within 120 seconds, the rate of dissolution is determined by dividing the membrane thickness before immersion by the time required for dissolution. A 4.5% by mass aqueous solution of tetramethylammonium hydroxide is used as the alkaline solution.

The protolytically leaving group-containing copolymer of the present invention preferably has a structure comprising, as essential constituents, repeating units (B) and (C) and, as an optional constituent, repeating unit (A), each repeating unit being represented by the following general formula (1): 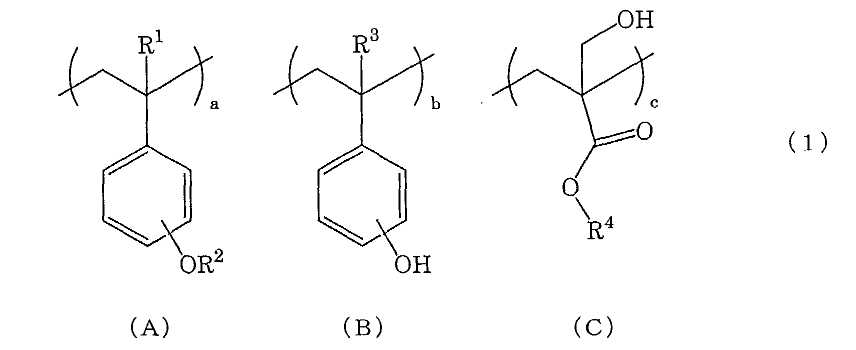 wherein R¹ and R³ are the same or different and each represents a hydrogen atom or a methyl group, R² represents a protolytically leaving group, R⁴ represents a substituted or unsubstituted alkyl group, and a, b and c represents the mole fractions, in the copolymer, of the repeating units (A), (B) and (C), respectively.

Preferably, the protolytically leaving group-containing copolymer of the present invention further comprises, as an essential constituent, a repeating unit (D) represented by the following general formula (2) : 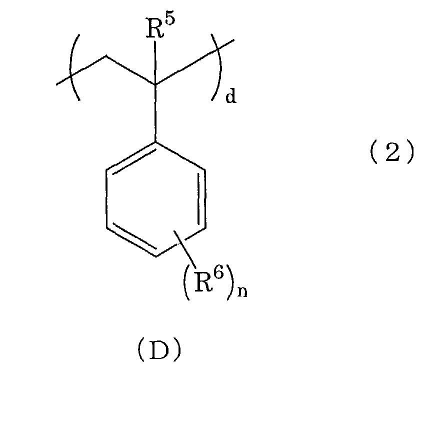 wherein R⁵ represents a hydrogen atom or a methyl group, R⁶ represents a substituent which will not undergo proton-induced elimination, n represents an integer of 0 to 5, and d represents the mole fraction of the repeating unit (D) in the copolymer.

As for the constitution of such copolymer, there may be mentioned (1) the constitution comprising the two repeating units (B) and (C) as essential constituents, (2) the constitution comprising the three repeating units (A), (B) and (C) as essential constituents, (3) the constitution comprising the three repeating units (B), (C) and (D) as essential constituents, and (4) the constitution comprising the four repeating units (A), (B), (C) and (D) as essential constituents. Among these repeating units, the three repeating units (A), (B) and (D) each may be the same species or different species. Among the above-mentioned four constitutions, the constitution (4) is preferred since the change in solubility in alkaline aqueous solutions after treatment with free protons as compared with that before such treatment is great and the adhesion to various substrates and/or the developability can be further improved and, further, satisfactory levels of chemical resistance and etching resistance can be developed. The mode of addition of these repeating units may include the random, block, and alternating addition modes, among others. The random addition mode is preferred, however.

The adhesion of the copolymer of the present invention to various substrates is brought about mainly by the repeating units (B) and (C). The restraint of dissolution before free proton treatment is brought about by the repeating units (A) and (C) and, as far as this characteristic is concerned, the contribution of (A) is great when (C) has no protolytically leaving group. Further, while the solubility in alkaline aqueous solutions after the above treatment is brought about by the repeating units (A), (B) and (C), the contribution of the repeating unit (C) is presumably greater as compared with the repeating unit (B), for instance, when R⁴ is a protolytically leaving group. Furthermore, the chemical resistance and etching resistance are brought about by the repeating units (A), (B) and (D) and, as far as this characteristic is concerned, it is considered that the contribution of the repeating unit (D), which has an aromatic ring having phenolic acidity like phenol nor protolytically reactive substituent, is main and great.

In accordance with the present invention, the effects of these repeating units are produced synergistically and all the characteristics referred to hereinabove are improved; thus, the use of the repeating units (B) and (C), which are essential constituents, does result in showing high levels of such characteristics as the changes in solubility in alkaline aqueous solutions after free proton treatment as compared with the solubility before such treatment and high levels of adhesion to substrates, developability, chemical resistance and etching resistance. The additional use of the repeating unit (A) or/and (D) as essential constituent(s) makes it possible for the above-mentioned characteristics to be shown at high levels and, as a result, the copolymer can be used in various fields of application.

Referring to the general formula (1), the mole fractions a, b and c of the respective repeating units in the protolytically leaving group-containing copolymer of the present invention are preferably such that c amounts to 5 to 50 mole % and a + b, namely the sum of a and b, to 50 to 95 mole %. These conditions allow the effects of the present invention to be fully produced. More preferably, the mole fractions are such that c amounts to 5 to 20 mole % and a + b to 80 to 95 mole %. The repeating unit mole fractions mentioned above are based on the sum of a, b and c for the respective copolymer-constituting repeating units, which is taken as 100 mole %.

In cases where the protolytically leaving group-containing copolymer of the present invention further comprises the repeating unit (D) as an essential constituent, the mole fractions a, b, c and d of the respective repeating units in the general formulas (1) and (2) are preferably such that c amounts to 5 to 45 mole %, a + b, namely the sum of the mole fractions a and b, to 50 to 90 mole %, and d to 5 to 30 mole %. These conditions allow the effects of the invention to be fully produced. More preferably, the mole fractions are such that c amounts to 5 to 20 mole %, a + b to 50 to 90 mole %, and d to 5 to 30 mole %. The repeating unit mole fractions mentioned above are based on the sum of a, b, c and d for the respective copolymer-constituting repeating units, which is taken as 100 mole %.

When it comprises the repeating unit (A), the protolytically leaving group-containing copolymer of the present invention preferably satisfies, with regard to the mole fractions a and b, the relation 0.2 ≦ b/(a + b) ≦ 0.95. Thus, it is preferred that when the sum of the repeating unit mole fractions a and b is taken as 100 mole %, b amounts to 20 to 95 mole %. When it is less than 20 mole %, sufficient levels of substrate adhesion and developability may not be obtained and, when it exceeds 95 mole %, the restraint of dissolution prior to free proton treatment may become insufficient, possibly leading to decreased developability. More preferably, b is not less than 50 mole % but not more than 90 mole %.

Suitable as the protolytically leaving group represented by R² in the general formula (1) given hereinabove are branched alkyl groups such as tert-butyl and isopropyl; cycloalkyl groups whose alicyclic skeleton is represented by the general formula CₙH₂ₙ (n being an integer of 3 or more), such as cyclobutyl, cyclopentyl, cyclohexyl and cycloheptyl; groups derived from cycloalkyl groups by substitution of one or more hydrogen atoms for a straight or branched alkyl group(s), such as 1-methylcyclohexyl, 1-ethylcyclohexyl, 1-methylcyclopentyl and 1-ethylcyclopentyl; groups derived from compounds having a spiro ring resulting from introduction of a bridging hydrocarbon into a cycloalkyl group such as spiroheptane or spirooctane; hetero atom-comprising functional groups such as tetrahydropyranyl, tetrahydrofuranyl, 3-oxocyclohexyl, methoxymethyl, ethoxymethyl, 1-methoxyethyl, 1-ethoxyethyl, 1-butoxyethyl, tert-butoxycarbonyl, trimethylsilyl and triethylsilyl; functional groups having substituent such as isobornyl, adamantyl, 1-methyladamantyl, 1-ethyladamantyl, and other substituents, or functional groups having ring such as norbornyl, bornene, menthyl, menthane, camphor, isocamphor, sesquiterpene, xanthone, diterpene or triterpene ring, or functional groups having a terpene ring derived from thujane, sabinene, thujone, carane, careen, pinane, norpinane, bornane, camphene, tricyclene or like compounds; and groups derived from steroid skeletons, such as cholesteric ring, bile acid, digitaloids and steroid saponins or from other polycyclic compounds. These may have one or more substituents selected from among hydroxyl, carboxyl, C₁-C₄ alkyl, hydroxyalkyl, carboxyalkyl and other groups.

Referring to the above-mentioned general formula (1), R² is preferably tert-butyl, tert-butoxycarbonyl, tetrahydropyranyl or trimethylsilyl among the protolytically leaving groups mentioned hereinabove as examples. The effects of the present invention are then produced to a fuller extent. In the copolymer of the present invention, hydrogen atoms bound to the carbon atoms of hydrocarbon constituting the copolymer skeleton may be substituted by other groups within the limits such that physical properties like free proton-induced eliminability and/or dissolution rate in alkaline aqueous solutions will not be sacrificed. The same applies to the aromatic rings to be introduced into the copolymer; thus, the aromatic rings may be substituted by one or more substituents other than the hydrogen atom.

Suitable as the substituent other than a hydrogen atom are organic groups such as alkyl groups (e.g. ethyl, tert-butyl); alkoxyl groups; carboxyl groups; hydroxyl groups; amino groups; sulfone groups, and halogen atoms, among others. The substituent other than a hydrogen atom may have the structure of a carboxylic acid salt, an ammonium salt, a quaternary ammonium salt, or a metal salt, for instance.

Preferred as the substituted or unsubstituted alkyl group represented by R⁴ in the general formula (1) are branched alkyl groups such as tert-butyl and isopropyl; cycloalkyl groups whose alicyclic skeleton is represented by the general formula CₙH₂ₙ (n being an integer of 3 or more), such as cyclobutyl, cyclopentyl, cyclohexyl and cycloheptyl; and groups derived from cycloalkyl groups by substitution of one or more hydrogen atoms for a straight or branched alkyl group(s), such as 1-methylcyclohexyl, 1-ethylcyclohexyl, 1-methylcyclopentyl and 1-ethylcyclopentyl. These may have one or more substituents selected from among hydroxyl, carboxyl, C₁-C₄ alkyl, hydroxyalkyl, carboxyalkyl and other groups.

Among the substituted or unsubstituted alkyl groups mentioned above as examples, those which are protolytically leaving groups are preferred as the group R⁴ in general formula (1) mentioned above. In particular, the group in which the carbon atom bound to the oxygen atom is a tertiary carbon atom, namely R⁴ in general formula (1), is preferably tert-butyl, 1-methylcyclohexyl, 1-ethylcyclohexyl, 1-methylcyclopentyl, 1-ethylcyclopentyl, 1-methyladamantyl or 1-ethyladamantyl.

The protolytically leaving group-containing copolymer according to the present invention preferably has a weight average molecular weight (Mw) of not less than 2,000 but not more than 50,000. When Mw is less than 2,000, poor heat resistance may result in some cases and, when it exceeds 50,000, the difference between the solubility in alkaline aqueous solutions after treatment with free protons and that before such treatment is insufficient, hence the effects of the present invention may not be produced to a satisfactory extent in certain cases. More preferably, it is not less than 2,500 but not more than 25,000, still more preferably not less than 3,000 but not more than 15,000. The term "weight average molecular weight" as used herein means the weight average molecular weight in terms of polystyrene equivalent as determined by gel permeation chromatography.

The protolytically leaving group-containing copolymer of the present invention is judiciously produced by carrying out the step of producing a copolymer comprising the repeating units (A) and (C) as essential constituents, optionally together with the repeating unit (D) as an essential constituent and then carrying out the step of forming the repeating unit (B) by exchanging the group represented by R², which the repeating unit (A) has, for a hydrogen atom through partial or total elimination of that group. Among the above-mentioned protolytically leaving group-containing copolymer of the present invention, such method of production makes it possible to efficiently produce (1) the constitution comprising the two repeating units (B) and (C) as essential constituents, (2) the constitution comprising the three repeating units (A), (B) and (C) as essential constituents, (3) the constitution comprising the three repeating units (B), (C) and (D) as essential constituents, and (4) the constituent comprising the four repeating units (A), (B), (C) and (D) as essential constituents. It is also possible to produce the copolymer of the present invention by polymerizing a monomer composition comprising a monomer constituting the repeating unit (B) and a monomer constituting the repeating unit (C), optionally together with a monomer constituting the repeating unit (A) and/or a monomer constituting the repeating unit (D), in respective appropriate amounts.

Preferred as the monomer constituting the above-mentioned repeating unit (A) are, among others, compounds represented by the following general formula (3) : 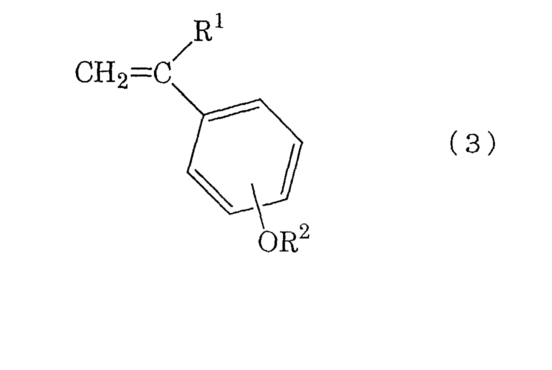 wherein R¹ and R² are as defined above. Suited for use as such compounds are compounds having a structure derived from hydroxystyrenes by addition of an olefin.

The above-mentioned hydroxystyrene includes, as suitable species, 2-hydroxystyrene, 3-hydroxystyrene, 4-hydoxystyrene and the like. These may be used singly or two or more of them may be used in combination. They may have one or more substituents selected from among alkyl, hydroxyl and carboxyl groups, halogen atoms, and so forth. 4-hydroxystyrene is preferred among others, however.

Suitable as the olefin mentioned above are linear olefins containing 4 to 20 carbon atoms, such as ethylene, propylene, 1-butene, isobutylene, and butadiene; cycloolefins such as cyclopentene, cyclohexene, and cyclopentadiene; polycyclic cycloolefins such as norbornylene, bicyclo[2.2.1]hepta-2-ene, bicyclo[2.2.1]hepta-2,5-diene, 5-norbornene-2-methanol, bicyclo[2.2.2]octa-2-ene, bicyclo[2.2.2]octa-2,5-diene, bicyclononadiene, dicyclopentadiene, methylcyclopentadiene dimer, bicyclopentadiene acetate, adamantane, and 2-methyleneadamantane; olefinic terpenes such as camphene, terpineol, terpinen-4-ol, α-terpinene, and γ-terpinene; olefin alcohols such as allyl alcohol, crotyl alcohol, and allylcarbinol; olefin aldehydes such as acrolein, methacrolein, and crotonaldehyde; olefin carboxylic acids such as acrylic acid, methacrylic acid, maleic acid, and succinic acid; olefin carboxylic acid esters such as acrylic acid esters, methacrylic acid esters, crotonic acid esters, and α-hydroxymethylacrylic acid esters; olefin ketones such as methyl vinyl ketone, ethylideneacetone, and mesityl oxide; vinyl ethers such as methyl vinyl ether, ethyl vinyl ether, and butyl vinyl ether; styrene, α-methylstyrene, acrylonitrile, methacrylonitrile, and the like. These may be used singly or two or more of them may be used in combination. These may have one or more substituents selected from among alkyl, hydroxyl and carboxyl groups, halogen atoms, and so forth. In preferred modes of embodiment, such olefin comprises isobutylene, preferably as a main component.

Preferred as the monomer constituting the repeating unit (A) are, in particular, 4-tert-butoxystyrene, 3-tert-butoxystyrene, and 2-tert-butoxystyrene, since the use of these facilitates the conversion of (A) to the repeating unit (B) by partial or total elimination. More preferred is 4-tert-butoxystyrene.

Suited for use as the monomer constituting the above-mentioned repeating unit (C) are compounds represented by the general formula (4): 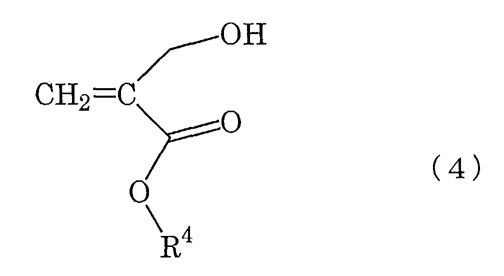 wherein R⁴ is as defined above. Suitable as such compounds are methyl 2-(hydroxymethyl)acrylate, ethyl 2-(hydroxymethyl)acrylate, tert-butyl 2-(hydroxymethyl)acrylate, isopropyl 2-(hydroxymethyl)acrylate, n-propyl 2-(hydroxymethyl)acrylate, n-butyl 2-(hydroxymethyl)acrylate, 1-methylcyclohexyl 2-(hydroxymethyl)acrylate, 1-ethylcyclohexyl 2-(hydroxymethyl)acrylate, 1-methylcyclopentyl 2-(hydroxymethyl)acrylate, 1-ethylcyclopentyl 2-(hydroxymethyl)acrylate, 1-methyladamantyl 2-(hydroxymethyl)acrylate, 1-ethyladamantyl 2-(hydroxymethyl)acrylate, and the like. In particular, those in which R⁴ is a protolytically leaving group are preferred and, among them, those in which the carbon atom bound to the oxygen atom is a tertiary carbon atom are more preferred. Still more preferred is tert-butyl 2-(hydroxymethyl)acrylate.

Usable as the monomer constituting the repeating unit (D) are compounds represented by the following general formula (5): 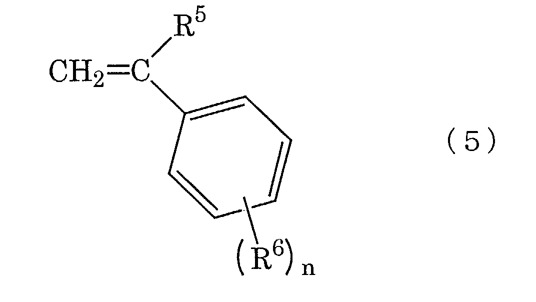 wherein R⁵ is as defined above, namely styrene, α-methylstyrene, vinyltoluene, ethylvinylbenzene, and the like.

In producing the copolymer having the constitution (1) or (2) by the above-mentioned method of copolymer production, the amounts of the repeating unit (A)- constituting monomer and repeating unit (C)-constituting monomer in the monomer composition comprising them as essential constituents are preferably selected within such a range that c amounts to 5 to 50 mole % and a + b to 50 to 95 mole %. In producing the copolymer having the constitution (3) or (4), the amounts of the repeating unit (A)-constituting monomer, repeating unit (C)- constituting monomer and repeating unit (D)- constituting monomer are preferably selected within such a range that c amounts to 5 to 45 mole %, a + b to 50 to 90 mole %, and d to 5 to 30 mole %.

In producing the protolytically leaving group-containing copolymer of the present invention, one or more monomers other than the monomers for constituting the essential repeating units may further be used unless the effects of the present invention are sacrificed. Suitable as such monomers are acrylic acid and esters thereof such as acrylic acid, methyl acrylate, ethyl acrylate and tert-butyl acrylate; methacrylic acid and esters thereof such as methacrylic acid, methyl methacrylate, ethyl methacrylate and tert-butyl methacrylate; nitrile group-containing monomers such as acrylonitrile and methacrylonitrile; amide group-containing monomers such as acrylamide and methacrylamide; olefins such as ethylene and propylene; fumaric acid; fumaric acid esters; maleic anhydride; maleic acid esters, and the like.

For the method of copolymerization in the process for producing the copolymer of the present invention, any of the methods of polymerization known in the prior art may be employed, such as the polymerization method using a polymerization initiator; the polymerization method involving radiation (e.g. ionizing radiation, electron beams) or ultraviolet irradiation; or the polymerization method involving heating. The polymerization may be carried out in the manner of bulk, solution, suspension, or emulsion polymerization, for instance. In particular, the mode of solution polymerization using a polymerization initiator is preferred, however.

Suited for use as the polymerization initiator in the above-mentioned copolymerization are peroxides such as benzoyl peroxide and di-tert-butyl peroxide; and azo compounds such as 2,2'-azobisisobutyronitirle, dimethyl 2,2'-azobis(2-methylpropionate) and 2,2'-azobis(2,4-dimethylvaleronitrile), among others. One or more of these may be used. The cyano group-free polymerization initiator dimethyl 2,2'-azobis(2-methylpropionate) is preferably used among others. As for the copolymerization conditions, the copolymerization is preferably carried out in an inert gas atmosphere, for example in a nitrogen gas atmosphere.

In carrying out the above-mentioned production method, the step of forming the repeating unit (B) by exchanging, the group represented by R², which the repeating unit (A) has, for a hydrogen atom, through partial or total elimination of that group is carried out. A method suited for application in such step comprises, for example, dissolving a copolymer comprising the repeating units (A) and (C) as essential constituents in a solvent and partly or totally eliminating the group represented by R² of the repeating unit (A), using an acid catalyst. On that occasion, the reaction conditions and so forth are preferably selected so that the mole fraction of the repeating unit (B) in the resulting copolymer may fall within the above-specified range. Suitable as the acid catalyst to be used in this case are those mentioned hereinabove or the like. For facilitating the control of the rate of reaction, the reaction is preferably carried out at 30 to 70°C, more preferably 40 to 60°C. Still more preferably, trifluoromethanesulfonic acid is used as the acid catalyst.

For confirming the existence of such essential structure as mentioned above in the copolymer of the present invention or in the copolymer produced by the production method according to the present invention, ¹H-NMR and/or ¹³C-NMR, for instance, can judiciously be applied.

The protolytically leaving group-containing copolymer of the present invention has a property such that, in the presence of free protons, it undergoes the action of those free protons and its solubility in alkaline aqueous solutions, among others, remarkably increases as compared with that before undergoing the action of protons. It shows good adhesion to substrates and is excellent in developability, chemical resistance and etching resistance. Therefore, it is useful as a copolymer that can judiciously be used in various fields of application in the chemical industry, such as a photolithographic material, or a low shrinkage material which utilizes the volume expansion of the olefin generated by the action of an acid catalyst.

### BEST MODES FOR CARRYING OUT THE INVENTION

The following examples illustrate the present invention in more detail. These examples are, however, by no means limitative of the scope of the invention. Unless otherwise specified, "part(s)" means "part(s) by weight", and "%" means "% by mass".

### Example 1 (Copolymer (A))

### Polymerization reaction

A 2,000-ml flask equipped with a stirrer, nitrogen inlet tube, thermometer and condenser was charged with 553 parts of ethyl acetate, and the temperature was raised to 80°C under nitrogen substitution. Then, a 15 percent by mass portion of a monomer mixture prepared in advance and composed of 699 g of p-tert-butoxystyrene (PBS) and 111 g of tert-butyl 2-(hydroxymethyl)acrylate (t-BHMA) was added to the flask, followed by addition, to the flask, of a 15 percent by mass portion of an initiator solution composed of 116 g of dimethyl 2,2'-azobis(2-methylpropionate) (product of Wako Pure Chemical Industries, trademark "V-601") and 194 g of ethyl acetate for initiating the polymerization. At 10 minutes after polymerization initiation, dropwise addition of the remaining portions of the monomer mixture and initiator solution was started; the monomer mixture was added dropwise over 5 hours and 50 minutes, and the initiator solution over 6 hours and 20 minutes. Thereafter, maturation was effected for 90 minutes. During the polymerization, the flask inside temperature was maintained at 80 ± 1°C. The molecular weight of the thus-obtained copolymer was determined using Tosoh's HLC-8120 GPC. The weight average molecular weight was 5,700, and the molecular weight distribution (Mw/Mn) was 1.68. The rate of polymerization of PBS was 90 mole % and the rate of polymerization of t-BHMA was 95 mole %, as estimated from residual monomer determination results. Accordingly, the content of the PBS unit in the structure of the copolymer obtained was calculated at 84 mole %, and that of the t-BHMA unit at 16 mole %.

### Selective elimination reaction

The copolymer obtained by the polymerization reaction was purified by methanol precipitation, 100 parts of the purified copolymer was dissolved in a mixed solvent composed of 200 parts of dioxane and 150 parts of acetone, and the solution was heated to 45°C using the same reactor as used for the polymerization reaction. Thereto was added 0.04 part of trifluoromethanesulfonic acid as the acid catalyst to initiate the selective elimination reaction. 10 minutes after addition of the acid catalyst, the passage of isobutene through the condenser was confirmed. During reaction, the reaction mixture was sampled, each sample was poured into at least 30 times as much volumes of deionized water for precipitation, and the precipitate polymer was filtered off through a Büchner funnel and rinsed well with deionized water. The polymer separated was dried in a vacuum drier, then dissolved in deuterated dimethyl sulfoxide, and the solution was subjected to NMR measurement. The extent of progress of the elimination reaction was monitored based on the ratio between the aromatic protons and tert-butyl group protons. When the elimination progressed to a structure such that the PBS unit amounted to 30 mole %, the p-hydroxystyrene (PHS) unit to 54 mole % and the t-BHMA unit to 16 mole %, the reaction mixture was quenched with ice water to terminate the reaction, and the reaction mixture was then poured into 4,500 parts of deionized water for purification by precipitation. The precipitate was filtered off and dried to give a copolymer A as a powder. As a result of molecular weight determination by GPC, the weight average molecular weight was found to be 4,900, and the molecular weight distribution (Mw/Mn) 1.59. Acid value determination and the NMR spectrometry revealed that the tert-butyl group in the t-BHMA unit remained uneliminated under the above reaction conditions.

### Physical property confirmation

For confirming that the photolithographic physical property of the copolymer obtained, 20 g of the copolymer (A) was dissolved in 50 g of dioxane, 0.2 parts of trifluoromethanesulfonic acid was added, and the reaction was carried out at 100°C for 1 hour. Silicon substrates rendered hydrophobic with tetramethyldisilazane were coated with the copolymer (A) before the reaction or the copolymer (A) after the reaction to a dry membrane thickness of 1 µm by spin coating method and then immersed in a 4.5% aqueous solution of tetramethylammonium hydroxide at 23°C. For each coated substrate, the rate of dissolution in the alkaline aqueous solution (m/sec) was determined by measuring the dissolved membrane thickness using ULVAC Japan's DEKTAK II A surface roughness measuring system. For membrane thickness measurements, a portion of each membrane was scraped off to reveal the silicon substrate, and the difference in level between the membrane surface and substrate surface was determined. The rate of dissolution was determined by subtracting the membrane thickness after immersion from the membrane thickness before immersion and dividing the difference by the time of immersion. In cases where the membrane was completely dissolved within 120 seconds, the rate of dissolution was determined by dividing the membrane thickness before immersion by the time required for dissolution.

The rate of dissolution of the copolymer (A) before the reaction was 300 X 10⁻¹⁰ m/sec and, after the reaction, the rate of dissolution was 3,000 X 10⁻¹⁰ m/sec; there was a great difference in rate of dissolution. The rate of dissolution in the alkaline aqueous solution thus changed greatly after the reaction with acid catalyst. In addition, no membrane peeling or cracking occurred during immersion in the aqueous solution of tetramethylammonium hydroxide, hence the adhesion to the silicon substrate was also good. Thus, the copolymer (A) was found to be a preferred polymer for photolithography. The results obtained are shown in Table 1.

### Example 2 (Copolymer (B))

The procedure of Example 1 was followed in the same manner except that the selective elimination reaction was terminated at the time point when the PBS unit amounted to 33 mole %, the PHS unit to 51 mole % and the t-BHMA unit to 16 mole %. Copolymer (B) was thus obtained and tested for physical property confirmation. The results are shown in Table 1.

### Example 3 (Copolymer (C))

The procedure of Example 1 was followed in the same manner except that a mixture of 614 g of PBS, 118 g of t-BHMA and 78 g of styrene was used as the monomer mixture and that the selective elimination reaction was terminated at the time point when the PBS unit amounted to 21 mole %, the PHS unit to 49 mole %, the styrene unit to 15 mole % and the t-BHMA unit to 15 mole %. Copolymer (C) was thus obtained and tested for physical property confirmation. The results are shown in Table 1.

### Example 4 (Copolymer (D))

The procedure of Example 3 was followed in the same manner except that the selective elimination reaction was terminated at the time point when the PBS unit amounted to 26 mole %, the PHS unit to 44 mole %, the styrene unit to 15 mole % and the t-BHMA unit to 15 mole %. Copolymer (D) was thus obtained and tested for physical property confirmation. The results are shown in Table 1.

### Example 5 (Copolymer (E))

The procedure of Example 3 was followed in the same manner except that the selective elimination reaction was terminated at the time point when the PBS unit amounted to 18 mole %, the PHS unit to 52 mole %, the styrene unit to 15 mole % and the t-BHMA unit to 15 mole %. Copolymer (E) was thus obtained and tested for physical property confirmation. The results are shown in Table 1.

### Example 6 (Copolymer (F))

The procedure of Example 1 was followed in the same manner except that a mixture of 583 g of PBS, 121 g of t-BHMA and 106 g of styrene was used as the monomer mixture and that the selective elimination reaction was terminated at the time point when the PBS unit amounted to 17 mole %, the PHS unit to 48 mole %, the styrene unit to 20 mole % and the t-BHMA unit to 15 mole %. Copolymer (F) was thus obtained and tested for physical property confirmation. The results are shown in Table 1.

### Comparative Example 1 (Copolymer (G))

The procedure of Example 6 was followed in the same manner except that the selective elimination reaction was terminated at the time point when the PBS unit amounted to 9 mole %, the PHS unit to 56 mole %, the styrene unit to 20 mole % and the t-BHMA unit to 15 mole %. Copolymer (G) was thus obtained and tested for physical property confirmation. The results are shown in Table 1.

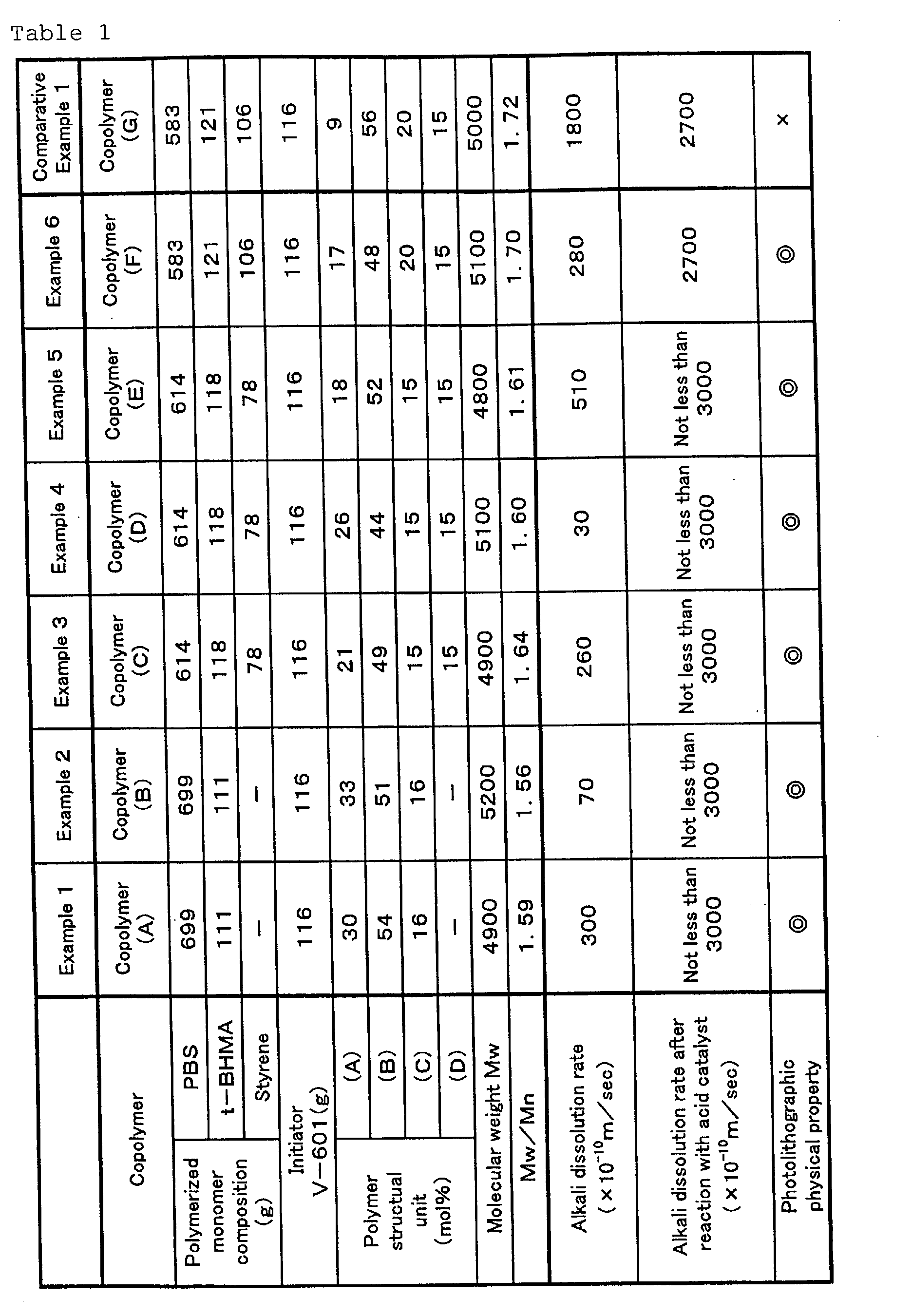

Remarks are made to Table 1.

Regarding the monomer compositions to be subjected to polymerization, PBS stands for p-tert-butoxystyrene, and t-BHMA for tert-butyl 2-(hydroxymethyl)acrylate. As regards the structural units of polymers, (A) is the structural unit constituted by PBS, (B) the structural unit derived from PBS upon selective elimination of the tert-butyl group, (C) the structural unit constituted by t-BHMA, and (D) the structural unit constituted by styrene.

The protolytically leaving group-containing copolymer of the present invention, which has the constitution described above, exhibits such characteristics as increases in solubility in alkaline aqueous solutions after free proton treatment as well as high levels of substrate adhesion, developability, chemical resistance and etching resistance and, therefore, can judiciously be used in various fields of application.

The present application claims priority under 35 U.S.C. §119 to Japanese Patent Application No.2002-126419, filed April 26, 2002, entitled "ALCOHOLIC HYDROXYL GROUP-, AROMATIC RING- AND PROTOLYTICALLY LEAVING GROUP-CONTAINING COPOLYMER." .

The contents of this application are incorporated herein by reference in their entirety.

## Claims

1. A protolytically leaving group-containing copolymer which is a copolymer having hydroxyl groups each bound to the main chain thereof via one carbon atom, aromatic rings, and protolytically leaving groups, wherein said protolytically leaving group-containing copolymer showing an alkali dissolution rate of 20 X 10⁻¹⁰ to 1,500 X 10⁻¹⁰ m/second prior to protolytically leaving group elimination.

2. The protolytically leaving group-containing copolymer according to Claim 1, wherein said protolytically leaving group-containing copolymer having a structure comprising, as essential constituents, repeating units (B) and (C) and, as an optional constituent, a repeating unit (A), each repeating unit being represented by the following general formula (1) : 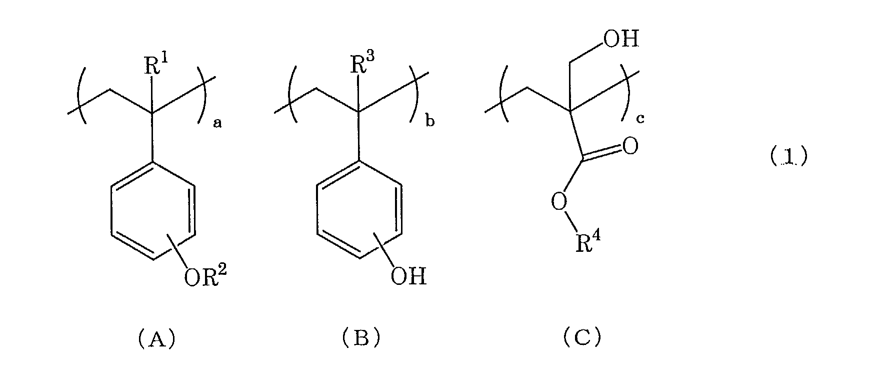 wherein R¹ and R³ are the same or different and each represents a hydrogen atom or a methyl group, R² represents a protolytically leaving group, R⁴ represents a substituted or unsubstituted alkyl group, and a, b and c represents the mole fractions, in the copolymer, of the repeating units (A), (B) and (C), respectively.

3. The protolytically leaving group-containing copolymer according to Claim 2, wherein said repeating unit mole fraction c is 5 to 50 mole % and the sum of the mole fractions a and b is 50 to 95 mole %.

4. The protolytically leaving group-containing copolymer according to Claim 2 or 3, wherein said repeating unit mole fractions a and b satisfy the relation 0.2 ≦ b/(a + b) ≦ 0.95.

5. The protolytically leaving group-containing copolymer according to Claim 2, 3 or 4, wherein said R⁴ is a protolytically leaving group.

6. The protolytically leaving group-containing copolymer according to Claim 2, 3, 4 or 5 which further comprises, as an essential constituent, a repeating unit (D) represented by the following general formula (2): 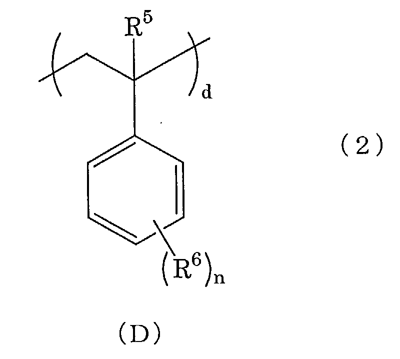 wherein R⁵ represents a hydrogen atom or a methyl group, R⁶ represents a substituent which will not undergo proton-induced elimination, n represents an integer of 0 to 5, and d represents the mole fraction of the repeating unit (D) in the copolymer.

7. The protolytically leaving group-containing copolymer according to Claim 6, wherein said repeating unit mole fraction c is 5 to 45 mole %, the sum of the mole fractions a and b is 50 to 90 mole %, and the mole fraction d is 5 to 30 mole %.
